# EUROPEAN PATENT APPLICATION

(11) **EP 0 595 776 A2**
(43) Date of publication of application: **04.05.1994**
(21) Application number: 93830366.6
(22) Date of filing: 10.09.1993
(51) Int. Cl.: G03F 7/12

(54) **Method and system for making a pre-emulsified fabric for printing matrix assemblies**

(30) Priority: 27.10.1992 IT MI922459
(71) Applicant: SAATI S.p.A., I-22070 Appano Gentile, Como (IT)
(72) Inventor: Canonico, Paolo, c/o SAATI S.p.A., I-22070 Appiano Gentile, Como (IT)
(74) Representative: Cicogna, Franco

(57) **Abstract**

The present invention relates to a method and system for making a pre-emulsified fabric to be used for making printing matrix assemblies suitable for textile, silk-screen and ceramic printing, which method comprises the step of depositing one or more layers of a photosensitive emulsion on polymeric fabrics, based on polyesters and polyamides, such as PETP, PA 6,6 and metalized PETP, or on other equivalent materials either of polymeric or not polymeric type.

## Description

### BACKGROUND OF THE INVENTION

The present invention relates to a method and system for making a pre-emulsified fabric for making printing matrix assemblies, suitable for the textile, silk-screen and ceramic printing.

As is known, for making matrix assemblies suitable for the silk-screen, textile and ceramic printing there are at present used fabrics which are tensioned and glued on suitable frames, and then are subjected to a series of degreasing, conditioning and/or abrading treatments; then they are sent to an emulsion depositing step, in which on the processed fabrics there is deposited a preliminarily sensitized emulsion.

Thus, for making a matrix assembly by a prior making method,there are conventionally required four steps, i.e. a fabric preparing step, an emulsion preparing step, an emulsion applying step in which the prepared emulsion is applied on the fabric, and a last drying step.

The first step comprises a chemical treatment of the fabric by means of suitable degreasing products, usually based on surface active agents, or by abrading products, in order to remove from the fabric any grease particles which may be present thereon, for example because of the contact of the fabric with the skin of the fingers, since these grease particles can prevent the printing matrix assembly from properly adhering to the material to be printed upon.

The second step provides for a mixing of the emulsion with suitable amounts of a sensitizing agent, either in powder form or in a concentrated solution form.

In order to provide a homogeneous applications, there is necessary, on the other hand, to prepare the emulsion several hours before its use, or to filter said emulsion by comparatively long-time operations.

The third step requires, in order to obtain a very good and accurate definition, a number of emulsion application steps which depends both on the composition of the emulsion and on the number of yarns constituting the fabric.

As is known, such a definition further depends on the type of the apparatus used for applying the emulsion, which apparatus convenionally comprises an even contour doctor element, which must be necessarily used with a comparatively low speed, in order to prevent air bubbles from being generated, which would provide the fabric with a very uneven surface.

The last step provides a drying of the emulsified fabric in a horizontal position thereof, with the side of the doctor assembly upwardly directed, this operation being performed in a dust-free place, away from any sources of white light, at a maximum temperature of 30°C.

In fact, an excessive amount of heat will cause the emulsion to become insoluble, thereby very fine lines can be hardly made.

As it should be apparent, the carrying out of the above mentioned operating steps is affected by several drawbacks, since it requires complex operations and treatments, with a very high time consume.

Moreover, the apparatus for performing the above mentioned operating steps are very expensive.

To the foregoing, it is to be further added that the above disclosed conventional methods originate great problems, of difficult solution, related to the storing of the emulsifying substances, as well as to the disposal of the processing waste.

### SUMMARY OF THE INVENTION

Accordingly, the aim of the present invention is to solve the above mentioned problems, by providing a method and system for making a fabric to be used for preparing printing matrix assemblies, which allow to eliminate the preliminarily preparing and emulsifying steps, so as to directly perform, in a very quick manner, the fabric tensioning operation, as well as the image engraving operations, according to a desired graphic pattern, to provide a very clear image.

Within the scope of the above mentioned aim, a main object of the present invention is to provide such a pre-emulsified fabric, which allows to overcome all of the problems related to the acquisition, preparing and storing of the emulsifying substances.

Another object of the present invention is to provide such a method and fabric which, owing to their peculiar features, provide very reliable operation characteristics and safety of use.

According to one aspect of the present invention, the above mentioned aim and objects, as well as yet other objects, which will become more apparent hereinafter, are achieved by a method for making a pre-emulsified fabric for making matrix assemblies to be used in the textile, silk-screen and ceramic printing, characterized in that said method comprises the step of depositing one or more layers of a photosensitive emuslion on polymeric fabrics based on polyesters and polyamides such as PETP, PA 6.6 and metalized PETP, or other equivalent materials, either of polymeric or a nor polymeric type.

### BRIEF DESCRIPTION OF THE DRAWINGS

Further characteristcs and advantages of the present invention will become more apparent hereinafter, from the following detailed disclosure of a preferred, though not exclusive, embodiment of a method and related system for making a pre-emulsified fabric according the invention, which is illustrated, by way of an indicative, but not limitative example, in the accompanying drawings, where:
Figure 1 is a general view of a finishing system for making the pre-emulsified fabric according to the invention, said system including spreading machines and at least a drying oven;
Figure 2 is a perpsective view of one of the spreading machines constituting an integrating part of the subject system.

### DESCRIPTION OF THE PREFERRED EMBODIMENT

The method for making a pre- emulsified fabric, to be used for making printing matrix assemblies, particularly for the textile, silk-screening and ceramic printing, according to the present invention, is essentially characterized in that it comprises a step of depositing one or more photo-sensitive emulsion layers on fabrics, preferably of a polymeric type, such as PETP, PA 6.6 and metalized PETP, or other equivalent materials, either of a polymeric or a not polymeric type.

The above mentioned fabrics can comprise either single-filament yarns or multiple-filament yarns and they are made with a cloth, satin, cross twill or the other equivalent wave; the surfaces of said fabrics being moreover chemically processed by means, for example, of conventional primer substances and/or being physically processed, for example by a plasma and corona processing method, so as to improve the adhesion characteristics of the fabric to the emulsion.

The characteristics of the different types of fabrics are very important for setting and adjusting the operating parameters of the finishing and spreading machines, during the production method.

In particular, with respect to the photo-sensitive substances, they can be of a hybrid type or of a pure photopolymeric type.

More specifically, the hybrid type of emulsion is formed by a mixture of:
10% polyvinyl alcohol (with a hydrolisis rate corresponding to 86/89% and with a polymerization rate of about 2400);
10% bi-functional epoxyacrylic monomer;
10% plasticizing substances;
0.1% isopropylthioxanthone photostarting agent;
0.4 diazocompounds photosensitizing agent;
69.5% water.

The thus made hybrid photosensitive emulsion is resistent against solvents, and has an ageing resistance or strength of about one year, which allows to achieve, during the making method, a temperature of 60°C without altering the fabric.

Other hybrid photosensitive emulsions are made by using the following component elements:
polyvinyl alcohol (with a hydrolisis rate between 75% and 99% and a polymerization rate between 500 and 2400);
carboxylated polyvinyl alcohols (with a hydrolisis rate between 75% and 95% and a polymerization rate between 500 and 900);
polyvinylacetate homopolymers and copolymers (vinyllaurates, vinylacetates, maleic acid esters, ethylene, vinylchloride, acrylic acid esters) (either plasticized or not);
acrylic pre-polymers to 100% or diluted in acrylic mono and/or polyfunctional monomers or emulsified in water (urethane acrylates, epoxide acrylates, polyester acrylates, melamine acrylates);
pre-polymers based on cathionic cycloaliphatic epoxy resins;
mono and/or polyfunctional acrylmonomers;
radical group and/or cathionic polymerization photostarting agents;
synergic amines;
photosensitizing agents.

The pure photopolymeric emuslion, on the other hand, comprises:
8% SBQ;
8% polyvinylacetate;
8% photopolymer (acrylmelamine);
76% water.

This emulsion is characterized by an unlimited resistance to ageing, with a good resistance against solvents and water, as the emulsion is catalized.

Among the pure photopolymeric emulsions which can be used for making a pre-emulsified fabric there are also included those defined by the following formula: 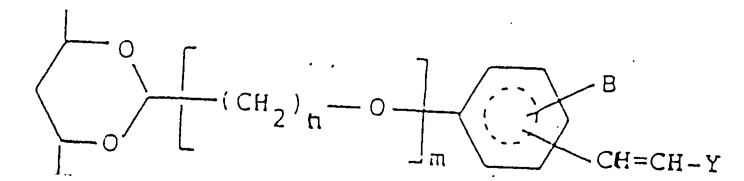
where 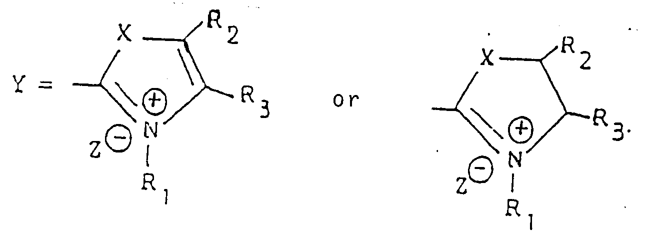
m = 0 or 1;
n = 0 or an integer number from 1 to 6, provided that as n = 0 then m = 0;
B =H or a terz-amine, a methoxy or ethoxy group;
X = 0, S, Se, or a bivalent NR₁ or C (R₁)₂, where
R₁ = H or an alkyl hydroxyalkyl, aryl, aralkyl group;
Z = an anion;
R₂ and R₃ are equal to one another or different from one another, each representing an alkyl, hydroxyalkyl, aryl, halo, nitro or cyano group, or R₂ and R₃, taken together, forming a part of the same aliphatic ring.

Moreover, said emulsions also comprise those emulsions defined by the following formula: 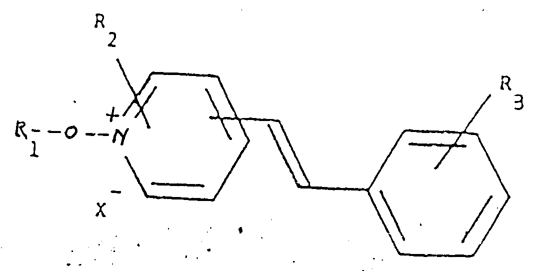
where:
R₁ represents either a substituted or not substituted alkyl group, a substituted or not substituted aralkyl group, or a hydrogen atom;
R₂ represents a substituted or not substituted alkyl group, a primary, secondary or terz amine group, a ciano, hydroxil or nitro group, a halogen or hydrogen atom or, together with a piridine ring to which it is affixed, forming a part of a quinoline group;
R₃ represents a chlorine or hydrogen atom or, together with the benzene ring to which it is affixed, representing a part of a naphtile group; X- represents an anion.

Moreover, it is possible to use a pure photopolymeric emulsion, comprising the following component elements: 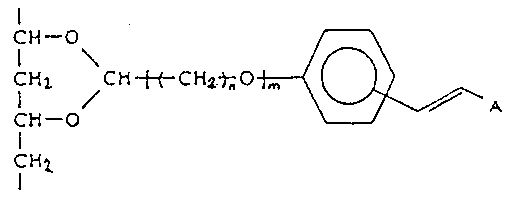
where:
m = 0 or 1;
n = an integer number from 1 to 6;
A represents: 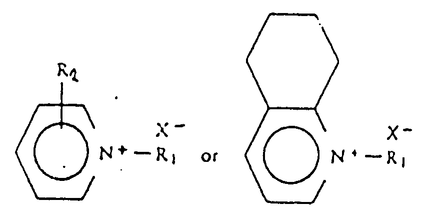
where:
R₁ represents a hydrogen atom or an alkyl or aralkyl group which can contain a hydroxil group, a carbamil group, or an ether or unsaturated linkage;
R₂ represents a hydrogen atom or a lower alkyl group, X- represents anhalido ion, a phosphate ion, a p-toluene-sulphonate ion, a methyl sulphonate ion or a mixture of two or more of these anions.

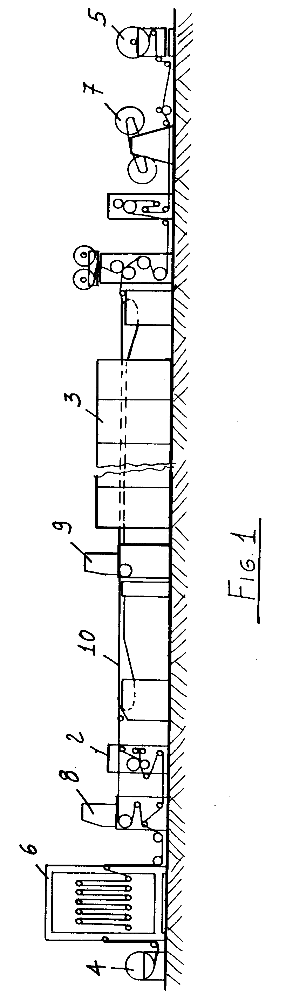

At present, the pre-emulsified fabric is obtained by a continuous process in a finishing system, shown in Figure 1 and generally indicated at the reference number 1.

Said system comprises emulsifying or spreading devices, generally indicated at the reference number 2, which are mounted immediately before the inlet of a drying oven 3.

From an operating standpoint, a suitable device 4 is provided, upstream of the system 1, for unwinding the bobbin of fabric to be processed, which will be then emulsified, by causing it to pass through one or more spreading machines 2, 8, 9 and 10 of any suitable type, and then through the drying oven 3.

Finally, the emulsified fabric is wound into bobbins again, by means of a winding device 5 arranged downstream of the system 1.

To cause the fabric to be always well tensioned and, accordingly, in a perfect planar condition, in particular during the emulsifying step and during its upstream winding step and downstream winding step, there are further provided tension adjusting devices generally indicated, respectively upstream and downstream, by the reference numbers 6 and 7.

With reference to the laying and spreading operation for laying and spreading the emulsifying substance, it should be apparent that it is performed through a continuous processing line.

In particular, this operating or processing line comprises a pair of spreading machines 8 and 9 which are separated from one another by a transfer spreading machine 10.

In particular, the used spreading machine comprises a spreading machine construction or framework supporting two opposite blades, one of which, mounted on a thickness micrometric adjusting device, is arranged on the top surface of the fabric, at a distance dependent on the desired emulsion thickness, whereas the other blade is so arranged as to contact the bottom surface of the fabric.

The top blade operates so as to provide, on the fabric, the desired emulsion layer, whereas the bottom blade is necessary to provide a proper counter-pressure, for obtaining a desired thickness eveness.

The emulsion, in particular, is supplied by falling from an emulsion tank the outlet flow rate of which is controllable, and being arranged above the top blade.

The fabric is displaced by means of suitable transmission cylinders.

Depending on the selected type of fabric and on the applied emulsifying substance type, the profile or contour of the opposite blades and the process parameters, such as the drying step temperature and the fabric tensione and displacement speed, must be suitably changed or modified.

In fact, as the free surface of the fabric decreases and/or as the viscosity of the emulsifying substance increases, it is necessary to operate with blades having progressively curved arrangements, so as to perfectly push the emulsion between the fabric mesh arrangement, while preventing the emulsion from passing beyond the fabric.

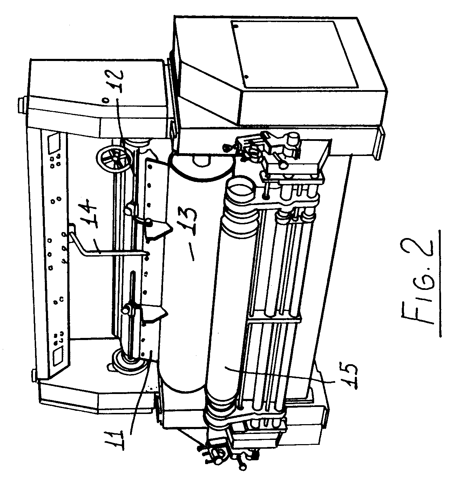

It is moreover to be pointed out that the laying of the emulsion on the fabric can be performed in several other manners, for example by using a spreading machine of the type shown in Figure 2.

In such a spreading machine, operating with a blade-cylinder system or assembly, the top blade 11 is anchored to a thickness micrometric adjusting device 12, whereas, instead of the bottom blade, there is used a spreading chromium plated and ground cylinder 13 suitable to provide a very even spreading of the emulsion.

In particular, the emulsion is supplied through a suitable outlet nozzle 14, arranged above the blade 11, with the fabric being displaced by means of transmission cylinders.

Alternatively, it is possible to also use a cylinder including a plurality of suitable holes arranged along the outer surface thereof, said holes allowing said emulsion to be easily supplied to be deposited on the fabric 15.

Another possible method, which is fully equivalent to the above disclosed methods, is that of progressively impregnating the fabric by causing it to pass with a controlled speed through an emulsion bath.

The pre-emulsified fabric, obtained by using the above disclosed system and method, provides a very good chemical resistance as well as a very good mechanical strength, which are particularly useful for the printing step.

In particular, this fabric can be very efficiently used in textile printing operations and in all of the applications using solvent and UV sensitive inks.

From the above disclosure it should be apparent that the invention fully achieves the intended objects.

The invention, as disclosed, is suceptible to several modifications and variations, all of which will come within the scope of the invention.

## Claims

1. A method for making a pre-emulsified fabric, to be used for making matrix assemblies suitable for the textile, silk screening and ceramic printing, characterized in that said method comprises the step of depositing one or more layers of a photosensitive emulsion on a polymeric fabric based on polyesters and polyamides, such as PETP, PA 6.6 and metalized PETP, or other quivalent materials, either of a polymeric or not polymeric type.

2. A method according to Claim 1, characterized in that said step of depositing one or more emuslion layers is performed on fabrics comprising either mono-filament or multiple-filament yarns and being made with a cloth, satin, cross-twill weave or the like, wherein surface portions of said fabrics are chemically processed by conventional priming agents and/or physically processed by a plasma and corona processing, in order to improve the adhesion properties of said fabric with said emulsion.

3. A method according to Claim 1, characterized in that said photosensitive emulsions are either of a hybrid type or of a pure photopolymeric type.

4. A method according to Claim 3, characterized in that said hybrid type emulsion is preferably formed by a mixture of:
10% polyvinyl alcohol (with a hydrolisis rate corresponding to 86/89% and with a polymerization rate of about 2400);
10% bi-functional epoxyacrylic monomer;
10% plasticizing substance;
0.1% isopropylthioxanthone photo starting agent;
0.4 diazocompounds photosensitizing agent;
69.5% water.

5. A method according to Claim 3, characterized in that said hybrid emulsion is obtained, in another preferred mixing configuration, by using the following elements:
polyvinyl alcohol (with a hydrolisis rate between 75% and 99% and a polymerization rate between 500 and 2400);
carboxylated polyvinyl alcohols (with a hydrolisis rate between 75% and 99% and a polymerization rate between 500 and 900);
polyvinylacetate homopolymers and copolymers (vinyllaurates, vinylacetates, maleic acid esters, ethylene, vinylchloride, acrylic acid esters) (either plasticized or not);
acrylic pre-polymers to 100% or diluted in acrylic mono and/or polyfunctional monomers or emulsified in water (urethane acrylates, epoxide acrylates, polyester acrylates, melamine acrylates);
pre-polymers based on cathionic cycloaliphatic epoxy resins;
mono and/or polyfunctional acrylmonomers;
radical group and/or cathionic polymerization photostarting agents;
synergic amines;
photosensitizing agents.

6. A method according to Claim 3, characterized in that said pure photopolymeric emulsion comprises a micture of:
8% SBQ;
8% polyvinylacetate;
8% photopolymer (acrylmelamine);
76% water.

7. A method according to Claim 3, characterized in that, in another preferred mixing formulation, said pure photopolymeric emulsions have the following formula: 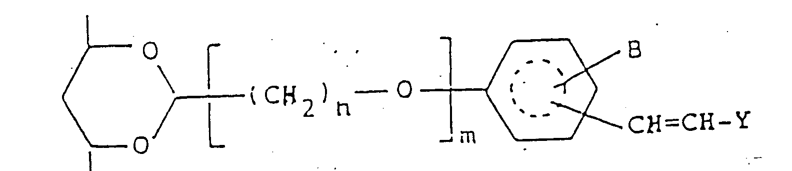 where: 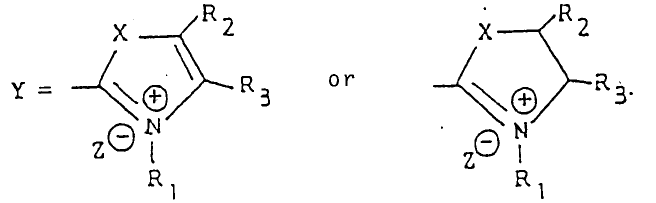 m = 0 or 1;
n = 0 or an integer number from 1 to 6, provided that as n = 0 then m = 0;
B = H or a terz-amine, methoxy or ethoxy group;
X = 0, S, Se, or a bivalent NR₁ or C (R₁)₂ , where
R₁ = H or an alkyl hydroxyalkyl, aryl, aralkyl group;
Z = an anion;
R₂ and R₃ are equal to one another or different from one another, each representing an alkyl, hydroxyalkyl, aryl, halo, nitro or cyano group, or R₂ and R₃, taken together, forming a part of the same aliphatic ring.

8. A method, according to Claim 3, characterized in that, in a further mixing formulation, the pure photopolymeric emulsions are represented by the following formula: 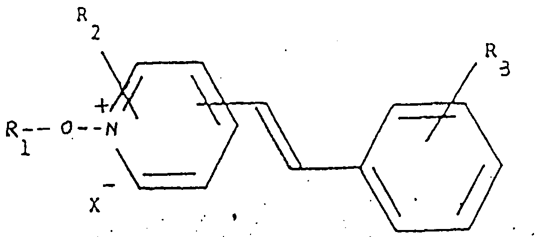 where:
R₁ represents either a substituted or not substituted alkyl group, a substituted or not substituted aralkyl group, or a hydrogen atom;
R₂ represents a substituted or not substituted alkyl group, a primary, secondary or terz amine group, a ciano, hydroxil or nitro group, a halogen or hydrogen atom or, together with a piridine ring to which it is affixed, forming a part of a quinoline group;
R₃ represents a chlorine or hydrogen atom or, together with the benzene ring to which it is affixed, representing a part of a naphtile group;
X- represents an anion.

9. A method according to Claim 3, characterized in that, in a further mixing formulation, the pure photopolymeric emulsions are defined by the following formula and components: 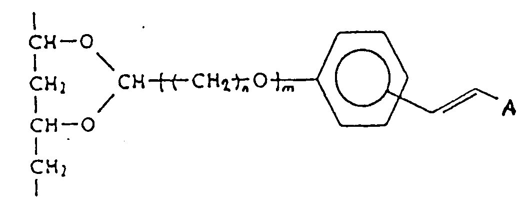 where:
m = 0 or 1;
n = an integer number from 1 to 6;
A represents: 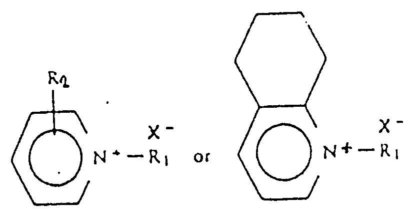 where:
R₁ represents a hydrogen atom or an alkyl or aralkyl group which can contain a hydroxil group, a carbamil group, or an ether or unsaturated linkage;
R₂ represents a Hydrogen atom or a lower alkyl group;
X- represents an halido ion, a phosphate ion, a p-toluene-sulphonate ion, a methyl sulphonate ion or a mixture of two or more of these anions.

10. A pre-emulsofied fabric to be used for making matrix assemblies suitable for the textile, silk screening and ceramic printing, characterized in that said fabric is made by a method according to Claim 1.

11. A system for making a pre-emulsified fabric, as obtained by a method according to Claim 1, characterized in that said system comprises emulsifying or spreading devices, mounted immediately before an inlet of a drying oven, and devices for unwinding bobbins of the fabric to be processed, arranged upwardly, and devices for winding into bobbins the finished fabric, arranged downstrem of the system, there being moreover provided, both downwardly and upwardly, devices for adjusting the tension on the fabric.

12. A system according to Claim 11, characterized in that said fabric is emulsified by a continuous process in a continuous processing line comprising one or more spreading machines adapted to be associated with a transfer spreading machine.

13. A system according to Claim 11, characterized in that, in a preferred embodiment thereof, the spreading machine comprises a spreading machine construction supporting two opposite blades one of which, mounted on a thickness micrometric adjusting device, is arranged on the top surface of the fabric, at a distance depending on a desired emulsion thickness, the other blade being arranged so as to contact the bottom surface of the fabric.

14. A system according to Claim 11, characterized in that each said spreading machine is supplied with an emulsion falling from an emulsion tank with an outlet controllable flow rate, said emulsion tank being arranged above the top blade, and the fabric being displaced by means of suitable transmission cylinders.

15. A system according to Claim 11, characterized in that, in a preferred embodiment thereof, each said spreading machine comprises a blade-cylinder assembly, in which there is arranged the top blade, anchored to a micrometric adjusting device for micrometrically adjusting the thickness, whereas, in the place of the bottom blade, there is used a chromium plated ground cylinder, and wherein the emulsifying substance exits on the fabric through a suitable exit nozzle arranged above the blade.
